# EUROPÄISCHE PATENTSCHRIFT

(11) **EP 0 387 526 B1**
(45) Veröffentlichungstag und Bekanntmachung des Hinweises auf die Patenterteilung: **27.01.1993**
(21) Anmeldenummer: 90102684.9
(22) Anmeldetag: 12.02.1990
(51) Int. Cl.: C25D 21/04

(54) **Vorrichtung zum Galvanisieren von Behandlungsgut in einer Reihe von hintereinander angeordneten Bädern**
Apparatus for the electrolytic treatment of work-pieces through a succession of baths
Dispositif pour le traitement électrolytique d'objets dans une suite de bains

(30) Priorität: 17.03.1989 DE 3908778
(43) Veröffentlichungstag der Anmeldung: 19.09.1990
(73) Patentinhaber: ATOTECH Deutschland GmbH, 10553 Berlin (DE)
(72) Erfinder: Kopp, Lorenz, D-8503 Altdorf (DE); Knorr, Heinrich, D-8501 Feucht (DE); Rossmann, Werner, D-8501 Feucht (DE)
(74) Vertreter: Effert, Udo, Dipl.-Ing.

(56) Entgegenhaltungen:
- DE-A- 3 501 469
- DE-A- 3 530 322
- PLATING POST, Jahrgang 1, Nr. 4, März 1960, Seiten 17-19; "Luchttoeblaas-installaties"

## Beschreibung

Die Erfindung geht aus von einer Vorrichtung gemäß dem Oberbegriff des Anspruches 1. Während man ursprünglich die Badbehälter oberseitig offen ließ und dabei in Kauf nahm, daß die sich oberhalb der Badflüssigkeit bildenden Dämpfe sich im Raum verteilten und dort nur unvollkommen abgezogen werden konnten, ist eine Vorrichtung gemäß dem Oberbegriff des Anspruches 1 in DE-OS 35 30 322 vorgeschlagen worden. Hierbei kann die Oberseite der Badebehälter, bzw. von darauf gesetzten Absaugvorrichtungen durch Deckel vollständig abgeschlossen werden. Nahezu unmittelbar unterhalb der Oberkante der Absaugvorrichtung sind in deren Wandung Lufteintrittsschlitze vorgesehen. Die Deckel besitzen unterseitig Wände, die sowohl der Zentrierung und Einführung der Deckel dienen als auch im abgedeckten Zustand der Badbehälter vor den Luftansaugschlitzen liegen und dabei einen Pfad erhöhten Luftwiderstandes im Luftweg zu diesen Ansaugschlitzen bilden. Wenn der Behälter oberseitig offen ist, um das zu behandelnde Gut einzuführen oder herauszunehmen, sind die Deckel zusammen mit der Auffangschale abgehoben und zur Seite verlagert. Die Bewegung von Deckel und Auffangschale ist also gekoppelt. Wenn auch mit der Anordnung nach DE-OS 35 30 322 insgesamt eine an sich anzustrebende Reduzierung der Abluftmenge bei aufgelegtem Deckel erreicht wird, so ist jedoch eine zu starke Reduzierung der Abluftmenge durch eine dichte Abdeckung des gesamten Behandlungsraumes sowohl bei anderen vorbekannten Anordnungen als auch beim Gegenstand von DE-OS 35 30 322 nachteilig. Im erstgenannten Fall können an Öffnungen für Leitungs- und Stromschieneneinführungen oder dergleichen schädliche Gase in die Raumatmosphäre austreten. Im zweitgenannten Fall besteht die Gefahr, daß der beim Saugvorgang im Behälterinnern bzw. zwischen den Absaugvorrichtungen entstehende Unterdruck die Deckel daran festhält, so daß ihr Abheben nur unter Überwindung dieses Unterdruckes möglich ist; gegebenenfalls dadurch behindert wird. Ferner ist die erläuterte Positionierung der Ansaugschlitze nachteilig. Hierbei wird ein sehr hoher Anteil an Umgebungsluft mit angesaugt, d.h. die Abluftmenge wird entgegen dem angestrebten Ziel dadurch entsprechend erhöht. Die angesaugte Luft ist auf dem sehr kurzen Weg zwischen Oberkante der Ansaugvorrichtung und deren Luftansaugschlitzen stark verwirbelt. Ferner wird der Bereich zwischen diesen Ansaugschlitzen und der Oberfläche der im Behälter befindlichen Badflüssigkeit nicht von der Ansaugluft durchströmt, so daß die dort befindlichen Dämpfe nicht abgesaugt werden können. Beim Einfahren des Behandlungsgutes in die Station und beim Ausheben des Gutes muß der Deckel abgehoben sein. Insbesondere beim Ausheben treten verstärkt die schädlichen Gase aus. Die Anordnung der Luftschlitze nach DE-OS 35 30 322 ist für diesen Betriebszustand sehr ungünstig, weil ein großer Anteil Umgebungsluft mit angesaugt wird. Die Wirkung der Absaugeeinrichtung wird dadurch sehr beeinträchtigt und kann auch durch Erhöhung der abgesaugten Luftmenge nur ungenügend ausgeglichen werden. Die erläuterte Koppelung der Bewegung Deckel mit der Bewegung Auffangschale hat u.a. den Nachteil, daß der zugehörige Transportwagen nicht als Spritzkabine mit beim Abspritzen des behandelten Gutes darunter befindlichen Auffangschale ausgestaltet werden kann.

Die Aufgabe der Erfindung besteht generell in einer Verbesserung der Absaugung der entstehenden Dämpfe bei Einhaltung des Zieles einer möglichst geringen Abluftmenge.

Zur Lösung dieser Aufgabe ist zunächst ausgehend vom Oberbegriff des Anspruches 1 die Anordnung gemäß dem Kennzeichen des Anspruches 1 vorgesehen. Hierdurch wird bei einer angestrebten Reduzierung der Abluftmenge wesentlich mehr an Dämpfen abgesaugt als beim Stand der Technik, da sich die Ansaugöffnungen oder -schlitze entsprechend tief in dem von Dämpfen erfüllten Raum zwischen Flüssigkeitsspiegel und Oberkante des Behälters oder der Absaugvorrichtung befinden. Der Deckel deckt die Oberseite des Behälters weitgehend ab, wobei aber bewußt dafür gesorgt ist, daß in dieser Abdecklage noch Luft zwischen den Deckelseitenkanten und dem Behälter bzw. der darauf befindlichen Absaugvorrichtung einströmen kann. Dies verhindert zum einen den zum Stand der Technik geschilderten Nachteil der Bildung eines zu starken, den Deckel daran ansaugenden Unterdruckes, der nur unnötigerweise die Verdunstung der meist bei höheren Temperaturen betriebenen Bäder fördert. Zum zweiten wird vor allen Dingen durch diese Luft der Raum zwischen Deckel und Ansaugschlitzen durchströmt und damit die darin befindlichen Dämpfe der Behandlungsflüssigkeit nach unten in die dort befindlichen Ansaugschlitze transportiert und durch diese abgezogen. Da die Absaugvorrichtung ständig läuft und damit ständig die vorgenannte Transportbewegung für die Luft mit den darin befindlichen Dämpfen gesorgt ist, können praktisch keine Dämpfe mehr in die Raumatmosphäre austreten. Aufgrund der großen Entfernung zwischen den Ansaugschlitzen und der Oberseite des Behälters bzw. der Absaugvorrichtung sind nachteilige Wirbelbildungen der angesaugten Luft vermieden. Solche Wirbelbildungen wären vor allen Dingen in den Stadien des Arbeitsprozesses einer solchen Galvanisieranlage schädlich, in denen der Deckel wegen des Einführens oder Heraushebens der Ware abgehoben und zur Seite geschwenkt sein muß. Die Auflager sorgen für eine richtige Positionierung der Deckel in der Abdecklage, so daß die Absaugvorrichtung selber hierzu nicht verwendet werden muß.

Mit den Merkmalen des Anspruches 9 wird die bereits erwähnte Verbesserung der Bewegung des Deckels einerseits und der Auffangschale andererseits erreicht. Dadurch können die Bewegungsvorrichtungen des Deckels und der der o.g. Schale je für sich relativ einfach gestaltet und gemäß den weiteren Ansprüchen auf verschiedene Seiten des Transportwagens verlagert werden. Außerdem besteht der Vorteil, daß der Transportwagen zugleich als Spritzkabine ausgebildet und das hierbei nach unten ablaufende Spritzwasser (einschließlich der abgespritzten Badflüssigkeit) von der Auffangschale aufgefangen und abgeleitet werden kann.

Weitere Vorteile und Merkmale der Erfindung sind den weiteren Unteransprüchen, sowie der nachstehenden Beschreibung und der zugehörigen Zeichnung von erfindungsgemäßen Ausführungsmöglichkeiten zu entnehmen.

In der Zeichnung zeigt:
Fig. 1-3: in der Seitenansicht Transportwagen und Badbehälter in verschiedenen Stadien des Arbeitsablaufes,
Fig. 4: eine Ansicht gemäß dem Pfeil IV in Fig. 1,

Die Fig. 5-8 sind in einem gegenüber der Darstellung der Figuren 1-4 größeren Maßstab gezeichnet:

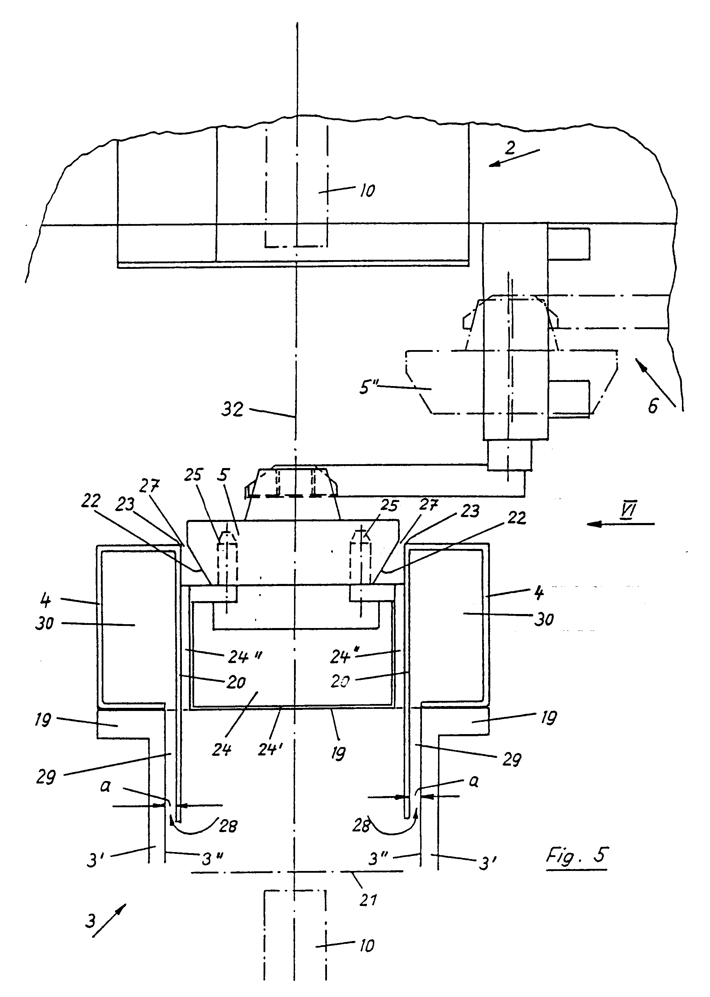

Fig. 5: den unteren Bereich des Transportwagens und den oberen Bereich des Badbehälters mit dazugehörigen Teilen in der Seitenansicht, wobei der Badbehälter und die Absaugstege geschnitten dargestellt sind,

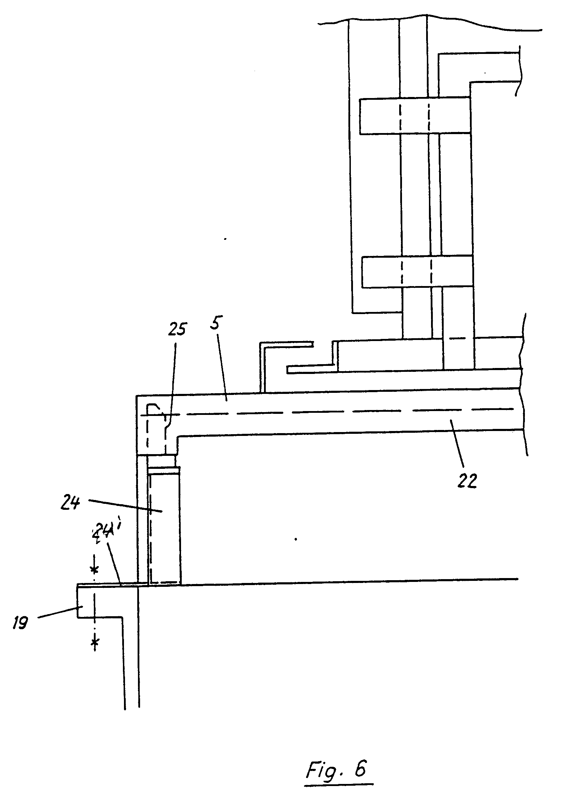

Fig. 6: eine Teilansicht gemäß dem Pfeil VI in Fig. 5,

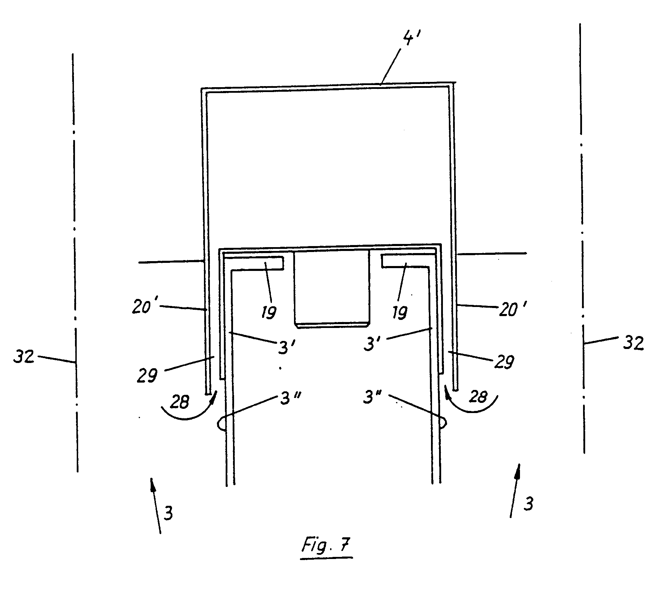

Fig. 7: eine weitere Ausgestaltungsmöglichkeit der Absaugstege,

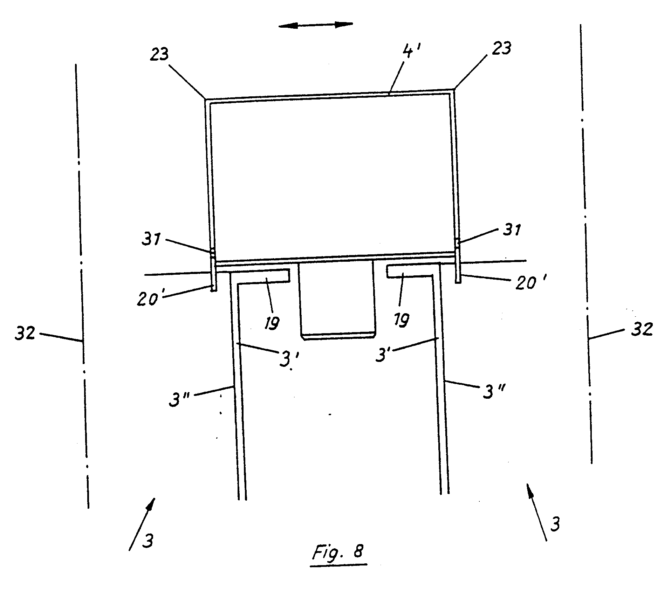

Fig. 8: eine weitere Ausführung der Erfindung.

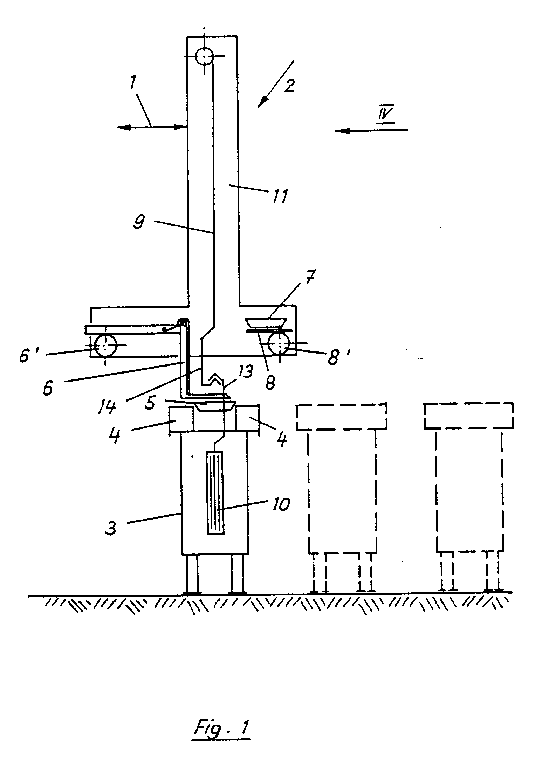

Fig. 1 zeigt einen Bereich einer Galvanisieranlage der Erfindung, wobei in einer Reihe hintereinander mehrere Behandlungsstationen vorgesehen sind, von denen eine mit durchgezogenen Linien im Prinzip komplett gezeichnet und weitere zwei Stationen nur gestrichelt angedeutet sind. Die Längsrichtung der Anlage ist durch den Pfeil 1 angegeben, dem auch die Bewegungsrichtung des Transportwagens 2 entspricht. Zu jeder Behandlungsstation gehört ein Badbehälter 3 mit Absaugstegen 4 und einem Deckel 5. Die nähere Ausgestaltung ist den Fig. 5 bis 8 zu entnehmen.

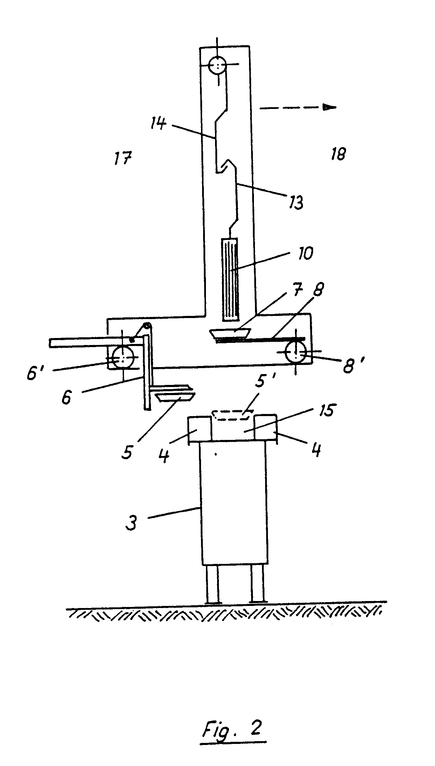

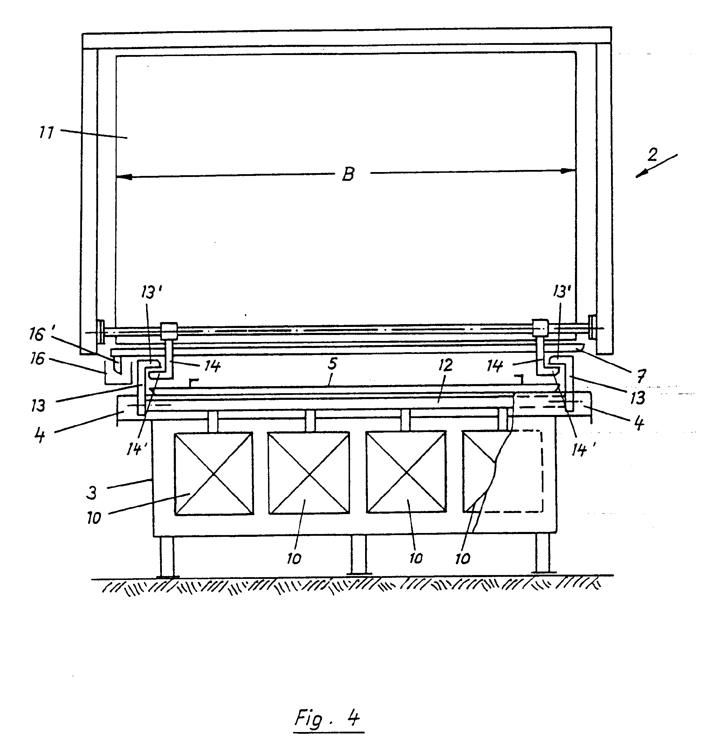

Am Transportwagen befinden sich eine Vorrichtung 6 zum Abheben und Bewegen des Deckels zur Seite, eine Auffangschale 7 mit zugehöriger Bewegungsvorrichtung 8 und die Anhebevorrichtung 9 für das Behandlungsgut 10. Ferner kann der Transportwagen bei 11 als Spritzkabine mit zugehörigen Spritzvorrichtungen (nicht dargestellt) ausgebildet sein. Die Ansicht gemäß Fig. 4 zeigt zum einen die vorgenannten Bauteile des Transportwagens und den oberen Bereich der darunter befindlichen Behandlungsstation sowie den Warenträger 12, dessen Tragarme 13 mit Abwinkelungen 13′ und die mit Abwinkelungen 14′ darunter greifenden Hebearme 14 des Transportwagens. Es ist ersichtlich, daß aufgrund der Gestaltung der Arme 13, 14 und der Richtung ihrer Abwinkelungen 13′, 14′ quer zur Fahrrichtung 1 des Transportwagens 2 dieser über die gesamte Länge der Anlage verfahren werden kann, ohne mit den Teilen 13, 13′ zu kollidieren. Soll er bei einer Behandlungsstation das Gut herausnehmen bzw. absenken so kommen dann die Abwinkelungen 14′ zur Anlage an die Unterseiten der Abwinkelungen 13′. So zeigt Fig. 1 wie der Transportwagen leer eine belegte Station angefahren hat. Seine Tragarme 14, 14′ sind in unterer Position. Der Deckel liegt noch auf der Oberseite des Behälters bzw. der Absaugstege auf und die Auffangschale ist zur Seite verfahren (Nichtgebrauchs-Position). Die Hebevorrichtung 6 für das Anheben des Deckels ist bereits in Arbeitsstellung gebracht worden. Dann (siehe Fig. 2) hebt Sie den Deckel 5 ab und verlagert ihn zur Seite. Somit ist die Oberseite 15 des Badbehälters offen, das zu behandelnde Gut 10 kann in die Lage gemäß Fig. 2 gehoben und erforderlichenfalls dort abgespritzt werden. Nach dem Herausheben des Gutes aus dem Behälter 3 wird die Auffangschale unter das ausgehobene Behandlungsgut gebracht und der Deckel 5 wieder in die ursprüngliche Abdecklage zurückgebracht (siehe gestrichelte Darstellung 5′). Dann wird der Transportwagen zu einer nächsten Behandlungsstation, zur Ablage, zu einer Reinigungsstation oder dergleichen verfahren. Es ist mit ein Vorteil der nach der Erfindung gestalteten Anordnung, daß der Transportwagen sowohl mit seinen Hebearmen 14, 14′ in unterer Position (Fig. 1) als auch in deren oberen Position gemäß Fig. 2 über beliebige viele Stationen hinweg gefahren werden kann, d.h. eine schnelle Abfolge der Transportvorgänge möglich ist.

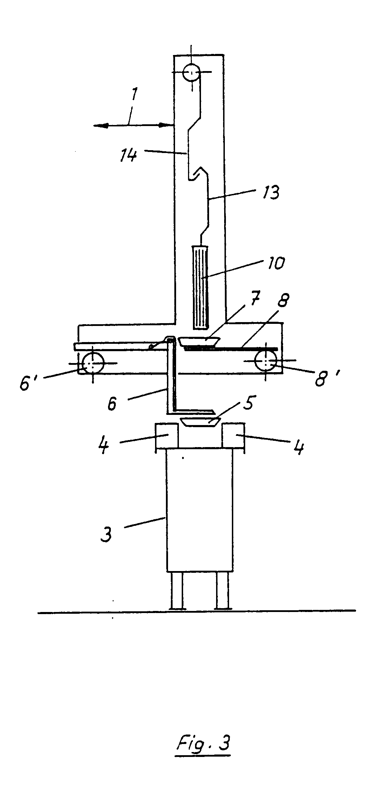

Die Ablage eines Behandlungsgutes vom Transportwagen in eine Behandlungsstation ist in Fig. 3 dargestellt. Beim Anfahren dieser Station ist das Behandlungsgut über die Arme 13, 14 angehoben und die Auffangschale 7 befindet sich in Arbeitsposition. Der Deckel 5 ist in der Abdecklage des Behälters 3. Dann wird die Bewegungsvorrichtung 6 des Deckels in die Arbeitslage gebracht und der Deckel wird abgehoben sowie zur Seite verfahren (siehe strichpunktierte Darstellung 5˝ in Fig. 5) . Außerdem wird die Auffangschale 8 zur Seite verfahren (ebenfalls nichts dargestellt). Anschließend wird das Behandlungsgut 10 in den Behälter 3 abgesenkt und der Deckel 5 wieder in die dargestellte Lage gebracht. Anschließend wird der Transportwagen 3 weggefahren.

Aus vorstehendem ergibt sich, daß die Bewegungsvorrichtungen 6 für den Deckel und 8 für die Auffangschale von einander unabhängig sind. Die Auffangschale 7 wird durch ihre Bewegungsvorrichtung 8 in der Transportrichtung 1 des Transportwagens 2 relativ zu diesem verschoben. Dabei kann sie mit Führungsrollen in entsprechenden Schienen (nicht dargestellt) des Transportwagens gleiten. Der zugehörige Antriebsmotor ist mit 8′ beziffert, während der Antriebsmotor der Bewegungsvorrichtung des Deckels mit 6′ bezeichnet ist. Die Nichtgebrauchs-Position der Auffangschale 7 gemäß Fig. 1 ist außerhalb der Bewegungsbahn der Arme 13, 14 und des Behandlungsgutes sowie des Warenträgers gelegen (Fig. 1, 4). Bei der bevorzugten Ausführungsform der Erfindung, in welcher der Transportwagen eine Spritzkabine aufweist nimmt in ihrer Auffangposition (Fig. 2, 3) die Auffangschale 7 vom Gut abtropfende Flüssigkeiten insbesondere Spritzwasser und Flüssigkeitsrückstände auf. Die von Auffangschale aufgefangene Flüssigkeit wird seitlich in eine Ablaufrinne 16 geleitet (siehe Fig. 4). Wesentlich ist beim Auffangen des Spritzwassers und der Rückstände aus einer Spritzkabine, daß sich die Auffangschale über die gesamte effektive Breite B des Transportwagens erstreckt, da diese Breite von der Spritzkabine eingenommen wird. Fig. 4 zeigt, daß bei Ausrüstung des Transportwagens mit einer Spritzkabine die Auffangschale 7 sehr weit nach außen gezogen sein, d.h. sehr breit sein muß, weil sie über den Bereich B der Spritzkabine 11 reichen muß. Die Spritzkabine ihrerseits muß so breit sein, daß der gesamte Warenträger darin eingefahren werden kann. Damit kann dann der Hubbalken nicht in die in Fig. 1 gezeigte Position gebracht werden, wenn die Auffangschale in der Mittenstellung ist. Aus diesen Gründen, und wenn dazu eine Auffangschale mit stetigem Auslauf über einen Entleerungsstutzen 16′ in eine Rinne 16 vorhanden ist (dies ist bei Vorhandensein eines Transportwagens mit Spritzkabine eine unbedingte Forderung), ist eine von der Auffangschalenbewegung unabhängige Vorrichtung für die Deckelbewegung erforderlich. Diesen Vorteil bietet die erfindungsgemäße Lösung. Bei der bekannten Anordnung nach DE-OS 35 30 322 sind die vorgenannten Vorteile nicht gegeben.

Die Fig. 1 bis 3 zeigen ferner, daß Deckel 5 und Auffangschale 7 bei ihrer Verlagerung in die Nichtgebrauchs-Position in jeweils zueinander entgegengesetzten Seiten 17, 18 des Transportwagens hin bewegt werden und sich damit in ihren Bewegungsabläufen und denen ihrer Transportmittel nicht gegenseitig stören.

Die Fig. 5 bis 8 zeigen Details der Ausgestaltung der Mittel zur Luftabsaugung und der Deckelbewegung, wobei aber die Auffangschale und die Mittel zu deren Bewegung aus Gründen der zeichnerischen Vereinfachung nicht noch einmal mit dargestellt sind.

Die Wandungen 3′ des Behälters laufen in obere Ränder 19 aus, auf denen die Absaugstege 4 gelagert und befestigt sind. Die jeweilige innen gelegene Seitenwand 20 dieser Absaugstege läuft parallel und in einem Abstand a zur Innenseite 3˝ der betreffenden Behälterwand und endet oberhalb der strichpunktierten Linie 21, welche die Position des maximal höchsten Flüssigkeitsspiegels angibt.

Der sich über die gesamte Länge des Behälters 3 ersteckende Deckel 5 (siehe auch Fig. 6) ist an seinen Seitenflächen 22 nach unten hin sich konisch verjüngend ausgebildet. Dies dient beim Aufsetzen des Deckels in Verbindung mit den oberen Innenkanten 23 der Absaugstege 4 für ein Zentrieren des Deckels zum Behälter und den Absaugstegen. Die endgültige Abdeck-Position des Deckels wird durch Halter 24 mit sogenannten Einweisungen 25 bewirkt, die oberseitig leicht konisch zulaufen und in entsprechende Öffnungen des Deckels passen. Gemäß dem Ausführungsbeispiel nach Fig. 5 und 6 können die Halter 24 aus Blech gebogene Konsolen sein, die mit Abbiegungen 24′ auf den Behälterrand 19 aufgesetzt sind. Auf diesen Konsolen, insbesondere abgebogenen Seitenrändern 24˝ ,sind die Einweisungen 25 aufgebracht und befestigt. Zwischen den Konsolen und den Seitenwänden 20 der Absaugstege besteht ein freier Raum, durch den Luft hindurchtreten kann. Dagegen verhindern die Konsolen, daß in waagerechter Richtung, also senkrecht zur Zeichenebene der Fig. 5, Luft von der jeweiligen Stirnseite des Raumes 26 her angesaugt werden kann. Es kann je ein solcher Halter 24 an jedem Ende der Absaugstege oder des Behälters angebracht sein (siehe auch Fig. 6).

Fig. 5 zeigt, daß die Abdeckung der Oberseite des Behälterinnenraumes 26 durch den Deckel nicht ganz vollständig ist, sondern daß bewußt an beiden Längsseiten des Deckels 5 Luftdurchtrittsschlitze 27 vorgesehen sind. Somit bewirkt die Absaugung durch einen Ventilator oder dergleichen, der ständig einen der Absaugung dienenden Unterdruck im Innern der Absaugstege 4 erzeugt, daß die Luft von außen durch diese Schlitze 27 in den Raum 26 eintritt und von dort gemäß den Pfeilen 28 in die Öffnungen 29 und von dort ins Innere 30 der Absaugstege strömt. Damit werden die oberhalb des Flüssigkeitsspiegels 21 im Raum 26 vorgesehenen Dämpfe fast vollständig mit erfaßt und abtransportiert. Die Position der durch die Spitzen der Pfeile 28 angegebenen Lufteintrittsschlitze in die Räume 29 muß nicht so sein, wie es in der Zeichnung dargestellt ist. Wesentlich ist, daß sie in einem die eingangs erläuterten Nachteile vermeidenden Abstand von der Oberkante 23 der Absaugstege liegen und die erforderliche Menge an Dämpfen des Innenraumes 26 durch die Luftströmung abgeführt werden kann.

Fig. 7 zeigt eine Absaugvorrichtung in Form eines Absaugsteges 4′, der sich über zwei einander gegenüberliegende Seitenwandungen 3′ zweier Behälter 3 erstreckt. Die beiden Seitenwände 20′ des Absaugsteges 4′ bilden jeweils zusammen mit den Wänden 3′ der Behälter die Luftführung 28, 29. Die Mittelachsen der Behälter 3 sind jeweils durch die strichpunktierten Linien 32 angedeutet.

Fig. 8 zeigt eine Anordnung ähnlich Fig. 7 mit einem Absaugsteg 4′, der sich über zwei Seitenwände 3′ erstreckt. Nur sind hier für die Absaugung der Luft in das Innere des Absaugsteges 4′ in dessen Wänden Schlitze 31 vorgesehen, die ebenfalls einen genügenden Abstand von der Oberseite, bzw. Oberkante 23 des Luftabsaugsteges 4′ haben. Die Absaugwirkung und die Vermeidung von Wirbelungen ist zwar gegenüber dem Ausführungsbeispiel der Fig. 5 bis 7 eingeschränkt, aber doch noch wesentlich gegenüber dem Stand der Technik vorhanden. Die Ausführung gemäß Fig. 8 hat den Vorteil, daß wenn nur wenig Platz in Richtung des oberhalb Fig. 8 gezeigten Doppelpfeiles vorhanden ist, man in dieser Richtung Raum gewinnt, da die Luftdurchtrittsöffnungen oder Schlitze 28 und die zugehörigen Wandteile 20, bzw. 20′ entfallen. Es versteht sich, daß der Wegfall der Lufteintritts- bzw. Ansaugöffnungen 28 und deren Ersatz durch die Lufteintritts- oder Ansaugschlitze 31 nicht nur bei einem Absaugsteg 4′ gemäß Fig. 8 sondern auch bei Verwendung von zwei Absaugstegen 4 gemäß den anderen Ausführungsbeispielen möglich ist, wobei dann ebenfalls auf die heruntergeführten Seitenwände 20 verzichtet werden kann.

## Patentansprüche

1. Vorrichtung zum Galvanisieren von Behandlungsgut, z.B. von elektronischen Leiterplatten, mit einer Anzahl in Reihe hintereinander angeordneten, an ihrer Oberseite offenen Bädern, mit Deckeln zum wahlweisen Abdecken dieser Oberseiten, mit einer Absaugung der im Badbehälter oberhalb des Flüssigkeitsspiegels der Badflüssigkeit befindlichen Dämpfe, und mit einem Transportwagen zum Ein- und Ausbringen des Behandlungsgutes in die bzw. aus den Bädern, dadurch gekennzeichnet, daß sich die Lufteintritts- bzw. Ansaugöffnungen (28) oder Ansaugschlitze (31) in einem solchen Abstand unterhalb des oberen Randes des Behälters (3), oder des oberen Randes (23) einer Einheit aus Behälter (3) und Absaugungen (4, 4′) befinden, daß Wirbelungen der eingesaugten Luft (27) weitgehend vermieden sind und ein wesentlicher Teil der Flüssigkeitsdämpfe im Raum (26) oberhalb des Flüssigkeitsspiegels (21) des Bades vom eingesaugten Luftstrom erfaßt wird, wobei jedoch die Ansaugöffnungen oder Ansaugschlitze sich oberhalb der maximalen Badhöhe (21) befinden, und daß die Höhenlage und Dimensionierung des Deckels (5) zum Behälter bzw. den Absaugungen so gewählt ist, daß zwischen Deckel und Behälter bzw. Absaugungen beidseitig ein Luftdurchtritt (27) besteht.

2. Vorrichtung nach Anspruch 1, dadurch gekennzeichnet, daß auf beiden Seiten des Badbehälters (3), bevorzugt auf dessen oberen Rändern (19) je ein Absaugsteg (4) angeordnet ist, der sich vom Badbehälter her nach oben erstreckt und daß die Ansaugöffnungen (28) dieser Absaugstege unterhalb des Behälterrandes (19) gelegen sind.

3. Vorrichtung nach Anspruch 2, dadurch gekennzeichnet, daß die Absaugstege (4) jeweils eine zum Badbehälterinnern gelegene Seitenwand (20) aufweisen, die im Abstand (a) von der jeweiligen Badbehälterinnenseite (3˝) und dazu parallel verläuft, sowie bis zu einer Höhenposition heruntergeführt ist, die oberhalb des Flüssigkeitsspiegels (21) gelegen ist und den gewünschten Abstand der dort befindlichen Lufteintrittsöffnung (28) von der Oberkante (23) der Ansaugstege (4) aufweist und daß die Seitenwände (20) mit den Innenseiten (3˝) Luftdurchtrittskanäle (29) bilden, die von den Lufteintrittsöffnungen (28) zum Innern (30) der Absaugstege (4) führen.

4. Vorrichtung nach Anspruch 1 oder 2, gekennzeichnet durch Lufteintrittsschlitze (31) in den Seitenwänden (20, 20′) des Absaugsteges(4, 4′), die ebenfalls einen genügenden Abstand von der jeweiligen Lufteintrittsoberkante (23) aufweisen.

5. Vorrichtung nach einem der Ansprüche 1 bis 4, dadurch gekennzeichnet, daß an der Behälterwandung (3′) oder der Absaugung (4, 4′) Halter (24) mit Auflagern oder sogenannten Einweisungen (25) für den Deckel (5) in seiner Abdecklage vorgesehen sind, wobei diese Einweisungen dem Deckel die erforderliche Position zum Badbehälter bzw. den Absaugungen in der Höhen- und Seitenlage geben.

6. Vorrichtung nach Anspruch 5, dadurch gekennzeichnet, daß die Halter Konsolen (24) sind, deren Einweisungen (25) konisch zulaufende Enden für das Einführen in entsprechende Öffnungen des Deckels (5) aufweisen.

7. Vorrichtung nach einem der Ansprüche 1 bis 6, dadurch gekennzeichnet, daß der Deckel (5) unterseitig konisch nach unten zueinander gerichtete Seitenwände (22) aufweist, die der Einführung des Deckels zwischen die Oberkanten (23) der Absaugstege (4) dienen.

8. Vorrichtung nach einem der Ansprüche 1 bis 7, dadurch gekennzeichnet, daß zwei nebeneinander liegende Badbehälter (3) an ihren zugewandten Seitenwänden (3′) von einem gemeinsamen Absaugsteg (4′) übergriffen sind, wobei dessen Seitenwände (20′) im Abstand (a) und parallel zu den entsprechenden Innenseiten (3˝) der Behälterwände (3′) verlaufen.

9. Vorrichtung nach einem der Ansprüche 1 bis 8, mit einer die vom behandelten Gut abtropfende Behandlungsflüssigkeit auffangenden Schale, dadurch gekennzeichnet, daß am Transportwagen (2) eine von der Bewegungsvorrichtung (8, 8′) der Auffangschale (7) unabhängige Vorrichtung (6, 6′) zum Abheben des Deckels (5) vom Behälter und zum Verlagern des abgehobenen Deckels in eine außerhalb der Bewegungsbahn des Behandlungsgutes (10) gelegenen Position, sowie zur Rückbewegung der vorgenannten Vorgänge vorgesehen ist.

10. Vorrichtung nach Anspruch 9, dadurch gekennzeichnet, daß die Auffangschale (7) am Transportwagen (2) sowohl in die Auffangposition unterhalb des im Transportwagen befindlichen Behandlungsgutes (10) als auch in eine außerhalb der Bewegungsbahn von Deckel und Warenträger mit Behandlungsgut gelegenen Nichtgebrauchs-Position durch gesondere Vorrichtungen (8) und einen gesonderten Antrieb (8′) verlagerbar ist.

11. Vorrichtung nach Anspruch 10, dadurch gekennzeichnet, daß die Auffangschale (7) relativ zum Transportwagen (2) in dessen Bewegungsrichtung (1) verschiebbar ist.

12. Vorrichtung nach einem der Ansprüche 9 bis 11, dadurch gekennzeichnet, daß der Transportwagen (2) mit einer Spritzkabine (11) für das Abspritzen des aus dem Badbehälter herausgehobenen Behandlungsgutes versehen ist und daß die Länge der Auffangschale (7) zumindest so groß ist wie die Breite (B) der Spritzkabine des Transportwagens.

13. Vorrichtung nach einem der Ansprüche 9 bis 12, dadurch gekennzeichnet, daß sich Bewegungsvorrichtung (6) und Antrieb (6′) des Deckels (5) einerseits und Bewegungsvorrichtung (8) und Antrieb (8′) der Auffangschale andererseits an einander entgegengesetzten Seiten (17, 18) des Transportwagens befinden.

## Claims

1. Device for the electroplating of articles, e.g. electronic circuit boards, with a number of baths open at the top and arranged in series one behind the other, with lids for covering the tops if required, with a suction system for the vapour formed above the liquid level of the bath solution and with a transport carriage for inserting or removing the articles into and out of the baths, characterized in that air inlet or suction openings (28) or suction ports (31) are located at such a distance beneath the upper edge of tank (3) or the upper edge (23) of a unit consisting of a tank (3) and draw-off devices (4, 4′) that turbulence of the sucked-in air (27) is largely avoided and a major part of the liquid vapour in the space (26) above the liquid level (21) of the bath solution is caught by the stream of air sucked in, the suction openings or suction ports being located, however, above the highest level (21) of the bath solution, and in that the height and dimensions of lid (5) in relation to the tank and draw-off devices are selected in such a way that between the lid and the tank and/or the draw-of devices there is a throughflow of air (27) on both sides.

2. Device in accordance with Claim 1, characterized in that on both sides of bath tank (3) and preferably on each of its upper edges (19) one draw-off bridge (4) is arranged which extends upwards from the bath tank, and in that the suction openings (28) of these draw-off bridges are located beneath the tank edge (19).

3. Device in accordance with Claim 1, characterized in that the draw-off bridges (4) have a side wall (20) which is directed in each case towards the bath tank interior and runs at a distance (a) from the particular bath tank inside (3˝) and parallel to this and is led down to a position above the liquid level (21) which ensures that the air inlet openings (28) located there have the required distance from the upper edge (23) of draw-off bridges (4), and in that the side walls (20) together with the insides (3˝) form air throughflow ducts (29) which lead from the air inlet openings (28) to the interior (30) of the draw-off bridges (4).

4. Device in accordance with Claim 1 or 2, characterized by air inlet ports (31) in the side walls (20, 20′) of draw-off bridge (4, 4′) which likewise have a sufficient distance from the particular upper edge (23) of the draw-off device.

5. Device in accordance with one of Claims 1 to 4, characterized in that on the tank wall (3′) or the draw-off devices (4, 4′), there are holders (24) with supports or so-called guides (25) for lid (5) in its closed position, these guides giving the lid the required position in relation to the bath tank or the draw-off devices as regards the height and the lateral position.

6. Device in accordance with Claim 5, characterized in that the holders are designed as brackets (24) whose guides (25) have tapering ends for introduction into the corresponding openings of lid (5).

7. Device in accordance with one of Claims 1 to 6, characterized in that the lower side of lid (5) has side walls (22) directed downwards and towards each other forming a cone which serves for introduction of the lid between the upper edges (23) of the draw-off bridges (4).

8. Device in accordance with one of Claims 1 to 7, characterized in that the adjacent side walls (3′) of two adjoining bath tanks (3) are overlapped by a common draw-off bridge (4′), the side walls (20′) of said bridge running at a distance (a) and parallel to the corresponding inner sides (3˝) of tank walls (3′).

9. Device in accordance with one of Claims 1 to 8, with a pan for catching the treatment liquid dripping off the articles, characterized in that the transport carriage (2) has a device (6, 6′) independent of the drive mechanism (8, 8′) of drip pan (7) for lifting lid (5) off the tank and for shifting the lifted lid into a position not within the path of motion of the articles (10) as well as for reversal of the above-described process.

10. Device in accordance with Claim 9, characterized in that drip pan (7) on transport carriage (2) can be shifted both into the drip-trap position beneath the articles (10) located in the transport carriage and into a non-use position outside of the path of motion of the lid and the article carrier, this being carried out by a special device (8) and a special drive (8′).

11. Device in accordance with Claim 10, characterized in that drip pan (7) can be shifted relative to transport carriage (2) in the latter's direction of motion (1).

12. Device in accordance with one of Claims 9 to 11, characterized in that transport carriage (2) is provided with a spray cabin (11) for spray-rinsing the articles lifted out of the bath tank and in that the length of drip pan (7) is at least the same as width (B) of the spray cabin of the transport carriage.

13. Device in accordance with one of Claims 9 to 12, characterized in that shifting device (6) and drive (6′) of lid (5) on the one hand and shifting device (8) and drive (8′) of the drip pan on the other hand are located on opposite sides (17, 18) of the transport carriage.

## Revendications

1. Dispositif pour la galvanisation d'articles à traiter, des cartes imprimées électroniques p. ex., avec plusieurs bains agencés en rangée les uns derrière les autres, ouverts sur leur partie supérieure, avec des couvercles pour recouvrir si souhaité ces parties supérieures, avec une aspiration des vapeurs se trouvant, dans le récipient de bain, au-dessus du niveau du liquide de bain, et avec un chariot de transport pour amener et retirer les articles à traiter des bains, ledit dispositif étant caractérisé en ce que les entrées d'air ou orifices d'aspiration (28) ou les fentes d'aspiration (31) son placés à une telle distance en-dessous du bord supérieur du récipient (3), ou du bord supérieur (23) d'une unité constituée du récipient (3) et d'aspirations (4, 4′), que les tourbillonnements de l'air aspiré (27) sont pratiquement exclus et qu'une partie essentielle des vapeurs de liquide dans l'espace (26) est saisie par le courant d'air aspiré au-dessus du niveau du liquide (21) du bain, les orifices d'aspiration ou fentes d'aspiration se trouvant toutefois au-dessus de la hauteur de bain maximum (21), et en ce que la position en hauteur et le dimensionnement du couvercle (5) par rapport au récipient ou aux aspirations soient choisis de manière à ce qu'entre le couvercle et le récipient ou les aspirations, il y ait un passage d'air (27) des deux côtés.

2. Dispositif suivant revendication 1, caractérisé en ce que des deux côtés du récipient de bain (3), et de préférence sur ses bords supérieurs (19), une traverse d'aspiration (4) partant du récipient de bain et s'étendant vers le haut soit disposée de chaque côté, et en ce que les orifices d'aspiration (28) de ces traverses d'aspiration soient placés en-dessous du bord (19) du récipient.

3. Dispositif suivant revendication 2, caractérisé en ce que les traverses d'aspiration (4) présentent chacune une paroi latérale (20), placée contre l'intérieur du récipient, qui passe à distance (a) de la face interne correspondante du récipient (3˝) et parallèlement à celle-ci et est amenée vers le bas jusqu'à une position en hauteur qui est au-dessus du niveau du liquide (21) et présente la distance souhaitée de l'orifice d'entrée d'air (28), situé à cet endroit, par rapport au bord supérieur (23) des traverses d'aspiration (4), et en ce que les parois latérales (20) forment, avec les faces internes (3"), des canaux de passage d'air (29) qui mènent des orifices d'entrée d'air (28) à l'intérieur (30) des traverses d'aspiration (4).

4. Dispositif suivant revendication 1 ou 2, caractérisé par des fentes d'entrée d'air (31) dans les parois latérales (20, 20′) de la traverse d'aspiration (4, 4˝), qui présentent également une distance suffisante par rapport au bord supérieur correspondant de l'entrée d'air (23).

5. Dispositif suivant l'une quelconque des revendications 1 à 4, caractérisé en ce que sur la paroi du récipient (3′) ou sur l'aspiration (4, 4′), des appuis (24) avec supports ou "guides" (25) sont prévus pour le couvercle (5) dans sa position fermée, ces guides donnant au couvercle la position verticale et latérale nécessaire par rapport au récipient de bain ou aux aspirations.

6. Dispositif suivant revendication 5, caractérisé en ce que les appuis sont des consoles (24) dont les guides (25) présentent des extrémités coniques pour l'insertion dans des orifices correspondants du couvercle (5).

7. Dispositif suivant l'une quelconque des revendications 1 à 6, caractérisé en ce que le couvercle (5) présente sur sa face inférieure des parois latérales (22) ajustées en cône vers le bas les unes par rapport aux autres et servant à l'insertion du vouvercle entre les bords supérieurs (23) des traverses d'aspiration (4).

8. Revendication suivant l'une quelconque des revendications 1 à 7, caractérisé en ce que deux récipients de bain placés l'un à côté de l'autre (3) sont traversés sur leurs parois latérales avoisinantes (3′) d'une traverse d'aspiration commune (4′), les parois latérales (20′) de celle-ci passant à distance (a) et parallèlement aux faces internes correspondantes (3") des parois du récipient (3′).

9. Dispositif suivant l'une quelconque des revendications 1 à 8, avec un bac collecteur recueillant le liquide de traitement s'égouttant des articles à traiter, caractérisé en ce que sur le chariot de transport (2), un dispositif (6, 6′) indépendant du dispositif de mouvement (8, 8′) du bac collecteur (7) est prévu pour soulever le couvercle (5) du récipient et pour déplacer le couvercle soulevé dans une position située en-dehors de la trajectoire de mouvement des articles à traiter (10), et pour le mouvement rétrograde des opérations susmentionnées.

10. Dispositif suivant revendication 9, caractérisé en ce que le bac collecteur (7) peut-être déplacé, au niveau du chariot de transport (2), aussi bien dans la position de collection en-dessous des articles à traiter (10) se trouvant dans le chariot de transport que dans une position de garage située en-dehors de la trajectoire de mouvement du couvercle et du chariot d'articles par des dispositifs séparés (8) et un mécanisme de commande séparé (8′).

11. Disposition suivant revendication 10, caractérisé en ce que le bac collecteur (7) est ajustable par rapport au chariot de transport (2), et ce dans sa direction de mouvement (1).

12. Dispositif suivant l'une quelconque des revendications 9 à 11, caractérisé en ce que le chariot de transport (2) est pourvu d'une cabine d'arrosage (11) pour le rinçage des articles à traiter soulevé du récipient de bain, et en ce que la longueur du bac collecteur (7) est au moins aussi importante que la largeur (B) de la cabine d'arrosage du chariot de transport.

13. Dispositif suivant l'une quelconque des revendications 9 à 12, caractérisé en ce que le dispositif de mouvement (6) et le mécanisme de commande (6′) du couvercle (5) d'une part et le dispositif de mouvement (8) et le mécanisme de commande (8′) du bac collecteur d'autre part se trouvent sur des côtés opposés (17, 18) du chariot de transport.
